# EUROPEAN PATENT APPLICATION

(11) **EP 2 884 542 A2**
(43) Date of publication of application: **17.06.2015**
(21) Application number: 14191497.8
(22) Date of filing: 03.11.2014
(51) Int. Cl.: H01L 29/786, H03K 19/00, H01L 23/00, H01L 21/768

(54) **Integrated circuit device with power gating switch in back end of line**

(30) Priority: 10.12.2013 EP 13196413
(71) Applicant: IMEC VZW, 3001 Leuven (BE)
(72) Inventor: Raghavan, Praveen, 3001 Leuven (BE); Genoe, Jan, 3001 Leuven (BE); Steudel, Soeren, 3001 Leuven (BE)
(74) Representative: Clerix, André

(57) **Abstract**

The present invention is related to an integrated circuit device comprising a Front End Of Line portion and a Back End Of Line portion, and further comprising a number of power gating switches arranged to turn blocks of standard cells in the FEOL portion of the IC on or off, i.e. to connect or disconnect said blocks to or from a power supply that is external to the IC. In an IC of the invention, at least one of said power gating switches, and preferably all of said switches are transistors located in the metallization layers of the IC's BEOL portion. Preferably, the source, drain and gate electrodes of the power gating transistors are formed by metal lines or metal-filled via interconnects located within said metallization layers. The presence of the power gating switches in the BEOL portion allows to produce ICs with improved semiconductor area consumption and a decrease in IR losses compared to power gating switches located in the FEOL portion.

## Description

### Field of the invention

The present invention is related to microelectronic devices, in particular integrated circuits, equipped with power gating switches.

### State of the art.

The term 'power gating' refers to the application of switches in an integrated circuit (IC) design, configured to switch off the current to parts of the IC in order to save power. Power gating switches are routinely applied in current day ICs. However, they are applied in the Front end of line (FEOL) portion of the device, i.e. the portion obtained by processing (litho/etch, etc) of a semiconductor wafer. This approach allows to obtain so-called fine-grained power gating, with a large amount of power gating switches being integrated on the semiconductor surface, allowing to turn on and switch off a large amount of blocks of transistors in the FEOL portion. The problem is that this increases the required semiconductor surface. Furthermore, when a power gating switch is in the FEOL portion, a long current path is required from the access pins of an IC to the power network of a gated portion on the chip, leading to significant IR losses.

### Summary of the invention

The present invention is related to an integrated circuit device comprising a Front end of Line portion and a Back end of line portion, and further comprising a number of power gating switches arranged to turn blocks of standard cells in the FEOL portion of the IC on or off, i.e. to connect or disconnect said blocks to or from a power supply that is external to the IC. In an IC of the invention, at least one of said power gating switches, and preferably all of said switches are transistors located in the metallization layers of the IC's Back End Of Line portion (BEOL), i.e. the portion that comprises a sequence of metallization layers connecting the FEOL to the power supply. Preferably, the source, drain and gate electrodes of the power gating transistors are formed by metal lines or metal-filled via interconnects located within said metallization layers. The presence of the power gating switches in the BEOL portion allows to produce ICs with improved semiconductor area consumption and a decrease in IR losses compared to power gating switches located in the FEOL portion. The invention is in particular related to a device as disclosed in the appended claims.

The invention is thus related to an integrated circuit device comprising a front-end-of-line portion and a back-end-of-line (BEOL) portion, the BEOL portion comprising a plurality of metallization layers, said layers comprising metal lines and metal-filled interconnect vias, the IC further comprising a plurality of power gating transistors wherein at least one of said power gating transistors is located in said BEOL portion.

According to a preferred embodiment, said at least one power gating transistor in the BEOL portion comprises a gate electrode, a source electrode and a drain electrode, a channel region and a gate dielectric region, wherein said gate, source and drain electrodes are formed by metal lines or metal-filled interconnect vias of said metallization layers.

Said channel region may be a planar semiconductor layer, wherein said gate dielectric region is a planar layer of dielectric material and wherein said layers form a stack of layers between the gate electrode on the one hand and the source and drain electrodes on the other hand.

According to an embodiment, said gate electrode is formed by a metal line in a first metallization layer, and the source and drain electrodes are formed by metal-filled interconnect vias in a second metallization layer directly on top of the first metallization layer. According to another embodiment, said source and drain electrodes are formed by a pair of metal lines in a first metallization layer and the gate electrode is formed by a metal-filled via interconnect in a second metallization layer directly on top of the first metallization layer.

According to a further embodiment, said at least one power gating transistor in the BEOL portion comprises a gate electrode, a source electrode and a drain electrode, a channel region and a gate dielectric region, wherein said source and drain electrodes are formed by a pair of conductors, the first conductor being located in a first metallization layer, the second conductor in a second metallization layer which is directly on top of the first metallization layer, the source and drain electrodes being physically located essentially one directly above the other, with the channel region being located in between the source and drain electrodes and the channel region being in electrical contact with the source and drain electrodes, the channel region and gate dielectric region being located in a via opening located above the first conductor, the gate dielectric region surrounding the channel region, and wherein the gate electrode is a conductor in contact with the gate dielectric and formed at least partially surrounding said via opening. In the latter embodiment, second conductor may also be located in said via opening and/or said first conductor may be a metal line in the first metallization layer.

According to a preferred embodiment, said channel region is formed of Indium Gallium Zinc Oxide (IGZO). According to a specific embodiment, said power gating transistor is located in the three first metallization layers (M1,M2,M3) of the device.

### Brief description of the figures

Figure 1 illustrates the FEOL and BEOL portions of an IC according to the invention, with a power gating transistor in the BEOL portion.
Figure 2 shows an alternative lay-out of a power gating transistor in the BEOL portion.
Figure 3 shows a vertically mounted power gating transistor mounted in the BEOL portion of an IC according to the invention.
Figure 4 shows a process flow for producing a transistor that is applicable in an IC according to the invention.
Figure 5 shows a detail of the transistor of Figure 1.
Figure 6 shows a process flow for producing a vertical transistor applicable in an IC according to the invention.

### Detailed description of the invention

The invention is related to an integrated circuit device equipped with a plurality of power gating switches, wherein at least one of said power gating switches is a transistor located in the Back end of Line (BEOL) portion of the IC. In the context of the present description, the following definitions of the Front end of Line (FEOL) portion and BEOL portion of an IC are applicable. The FEOL portion comprises a processed semiconductor substrate, provided with a plurality of transistors and other devices, obtained by or obtainable by processing (e.g. litho/etch, STI, N+/P+ implants, gate deposition) a semiconductor wafer. The BEOL portion comprises a sequence of metallization layers for establishing electrical current paths between the FEOL portion and external terminals to which the IC is connected.

According to preferred embodiments, said power gating switch located in the BEOL portion is a transistor having a gate electrode and source and drain electrodes, with said electrodes being formed by metal lines or metal-filled via interconnects present within the metallization layers of said BEOL portion. The term 'via' is known in the art (Vertical Interconnect Access), as a connection between metal lines in the BEOL. In an IC according to the invention, none of said gate, source and drain electrodes is formed by contact bumps at the top level of the device.

The power gating transistor further comprises a channel region and a gate region that may be respectively in the form of a planar layer of a semiconductor material and a planar layer of a suitable gate dielectric material. The semiconductor layer is preferably a so-called thin film semiconductor layer deposited during BEOL processing, enabling to produce transistors with low leakage in the BEOL. The term thin film semiconductor refers to semiconductor material that can be deposited in the form of a layer of the material onto a supporting surface. A preferred choice for such thin film semiconductor material is Indium Gallium Zinc Oxide (hereafter referred to as IGZO). The term IGZO encompasses all realizable varieties of the compound InₓGa_{y}Zn_{z}O_{w} in terms of the values of the atomic numbers x,y,z and w, for example In₂Ga₂ZnO₇. The use of IGZO or an equivalent material also allows to produce a power gating switch with a short turn-on and turn-off time due to the low threshold voltage of the transistor. This allows to apply power gating with low overhead in terms of power supply (low increase of required Vdd due to power gating). Also, the fact that the power gating switch is physically present in the current path between the access pins of the IC and the FEOL portion allows to reduce IR losses.

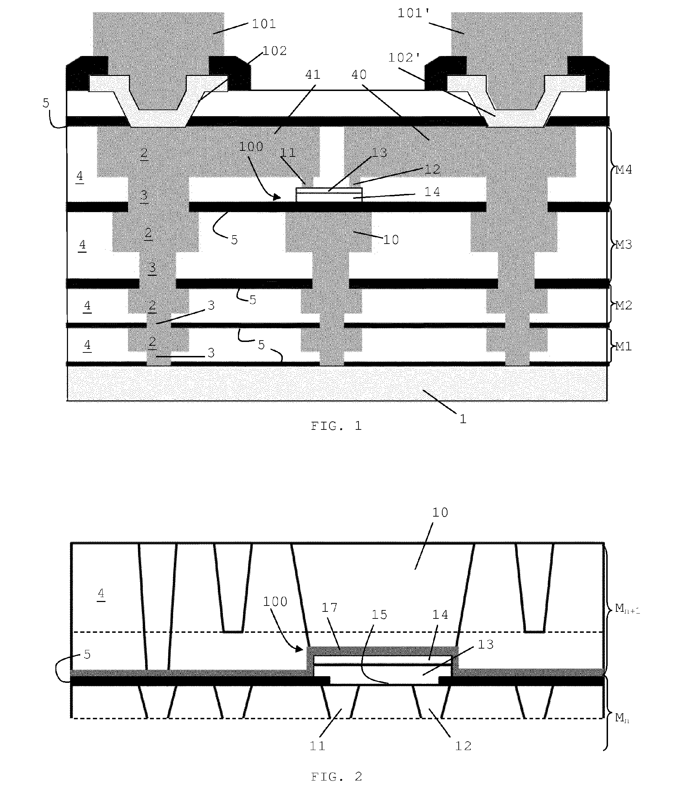

Figure 1 shows a possible implementation of a power gating transistor 100 implemented in a pair of two adjacent metallization layers in the BEOL portion of an IC device. The device's FEOL portion is schematically shown as a rectangle 1, with the BEOL portion shown in a little more detail, as a sequence of metallization layers M1, M2, M3 and M4. Normally more than 4 metallization layers are present in an IC (currently up to 9 in 28nm technology), but only four are shown for the sake of simplifying the drawing. Cupper contact bumps 101/101' contact the upper metallization layer M4 through Aluminium contact pads 102/102'. Each metallization layer comprises an upper level comprising metal (preferably copper) lines 2 running in the plane of the layer, and a lower level comprising metal-filled via interconnects 3 for connecting the metal lines 2 to the underlying layer. The metal lines and via interconnects are embedded in a layer of intermetal dielectric 4 (e.g. SiO₂). Another dielectric layer 5, which may have one or more functions, for example the functions of a passivation layer, etch stop layer or diffusion barrier, may be present between the metallization layers, provided with openings where a connection is needed from one metallization layer to the next. Layers 5 may for example be layers of SiCN. The gate electrode 10 of the transistor is formed by a metal line in metallization layer M3, whereas the source and drain electrodes 11/12 are formed by two interconnect vias in metallization layer M4. A thin film semiconductor layer 13 forms the channel layer of the transistor. The thin film semiconductor layer is present on top of a dielectric layer 14, deposited onto the dielectric layer 5 that is present between the metallization layers M3 and M4. The thin film semiconductor layer may be a layer of IGZO (as defined above). The dielectric layer 14 may be a layer of Al₂O₃ or any other material or stack of materials qualifying as a high quality gate dielectric. The dielectric layers 5 and 14 together play the part of the gate dielectric in the power gating transistor 100. In the embodiment shown, the source and drain electrodes 11/12 are described as 'interconnect vias', even though they do not 'connect' the M4 and M3 layer electrically. In defining the scope of the present invention and the appended claims, the term 'interconnect via' comprises any conductor obtainable by standard processing steps for producing actual interconnect vias in the BEOL, also when these interconnect vias are interrupted by a dielectric layer.

Figure 2 shows another embodiment, wherein the source and drain electrodes of the power gating transistor 100 are formed by a pair of metal lines 11/12 in a lower metallization layer Mₙ, while the gate electrode is formed by a metal-filled via interconnect 10 in the upper metallization layer Mₙ₊₁. In this case, an opening 15 is present in the dielectric layer 5 between the two metallization layers, and a thin film semiconductor layer 13 forming a channel layer is deposited in said opening, on top of the source and drain electrodes 11/12. A further dielectric layer 14 is present on top of the channel, preferably a high quality gate dielectric material such as Al₂O₃. Another dielectric layer 17 is present on the dielectric layer 14 and on the whole of the surface. Layer 17 may be an etch stop layer required during the etching of openings in the intermetal dielectric 4. The stack of the first dielectric 14 and the etch stop layer 17 together form the gate dielectric of the power gating transistor 100. If the layer 14 can itself act as an etch stop layer, layer 17 may be omitted or vice versa, if the etch stop layer 17 is a sufficiently good gate dielectric material, layer 14 could be omitted. The channel layer 13 is a thin film semiconductor layer, preferably a layer of IGZO.

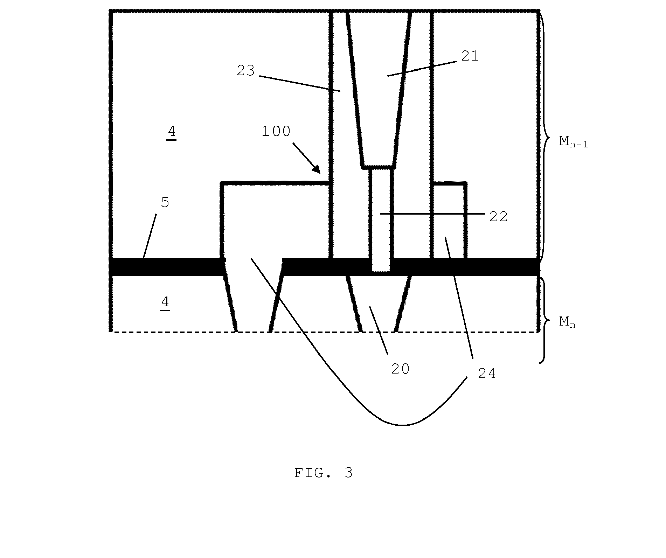

Figure 3 shows another embodiment of a power gating transistor 100 in the BEOL portion of an IC. The transistor is formed in two neighbouring metallization layers Mₙ and Mₙ₊₁, between a first metal line 20 in layer Mₙ and a metal conductor 21 in layer Mₙ₊₁, the metal line 20 and the conductor 21 respectively forming the source and drain electrodes of the power gating transistor. The source and drain electrodes are thus physically located essentially one directly above the other. A via opening in Mₙ₊₁ and located above the metal line 20 comprises a central channel portion 22, surrounded by a gate dielectric material 23. The gate electrode is a metal conductor 24 that surrounds at least partially the gate dielectric material 23. The conductor 21 in Mₙ₊₁ is equally located in the via opening. The channel material of the central channel portion 22 may be IGZO. The gate dielectric material 23 may be Al₂O₃ or an equivalent high quality gate dielectric material.

The power gating transistor 100 according to any of the above described embodiments is implemented within the BEOL portion of the IC, i.e. incorporated within the metallization layers of the IC. This approach allows the designer a high degree of flexibility in terms of defining the degree of fine grained or coarse grained power gating, without significant overhead in terms of semiconductor area. The location of the power gating switch in the vertical current path between the access pins of the IC and the FEOL portion also allows to reduce IR losses. With respect to the last point (IR losses), the embodiment of Figure 2 is preferred, i.e. with the gate electrode 10 at the bottom of the transistor 100, given that the signal for activating the power gating generally originates in the FEOL portion.

Apart from the physical location of the power gating switch, the incorporation of power gating transistors according to the invention in the electrical network of the IC is not different from power gating switches that are presently implemented in the FEOL. Blocks of standard cells in the IC's FEOL portion are defined on the chip, between Vdd and Vss rails through which the cells receive electrical power. The Vdd/Vss rails are connected to networks of Vdd and Vss lines in the BEOL, each network providing power to a block of standard cells. Power gating switches provide the capability of switching each network, and thereby each block, on or off individually.

preferably a plurality of power gating switches are provided between a power source (e.g. a metal line or a metal ring in one upper metallization layer connected to an external power supply), and the power network of a block. In the example of Figure 1, metal line 40 is connected to copper bump 101', which may be connected to the power source which can be an external supply voltage Vdd. Metal line 41 is then part of a Vdd power network configured to power a particular block on the FEOL portion 1 of the IC. The transistor 100 is configured to connect metal line 41 and thereby the Vdd network configured to power a particular block to the power source voltage Vdd and thereby activate said block on the FEOL portion, or to disconnect said network configured to power a particular block and thus said FEOL block, from the power source voltage Vdd.

It should be noted that the power source is not restricted to an external power source. The IC can contain an internal power source, for instance a voltage regulator or switched mode power supply. These internal power sources are embedded in the FEOL of the IC. The internal power source may further be connected to the outside world. In the case of a voltage regulator, this may be done to stabilize the regulator output, for example by means of a capacitor, the source remaining however internal to the IC.

It is preferred to implement power gating transistors according to the invention deep into the BEOL portion, i.e. in the metallization layers that are close to the FEOL portion, e.g. in metallization layer M1, M2, M3, in order to enable fine grained power gating of a large number of blocks of standard cells on the IC. In this way, the present invention allows fine grained power gating without excessive area consumption on the chip and with lower IR losses compared to ICs where the power gating switches are in the FEOL portion. According to an embodiment, a power gating transistor is located on the power delivery strips of the standard cell rows of the FEOL portion.

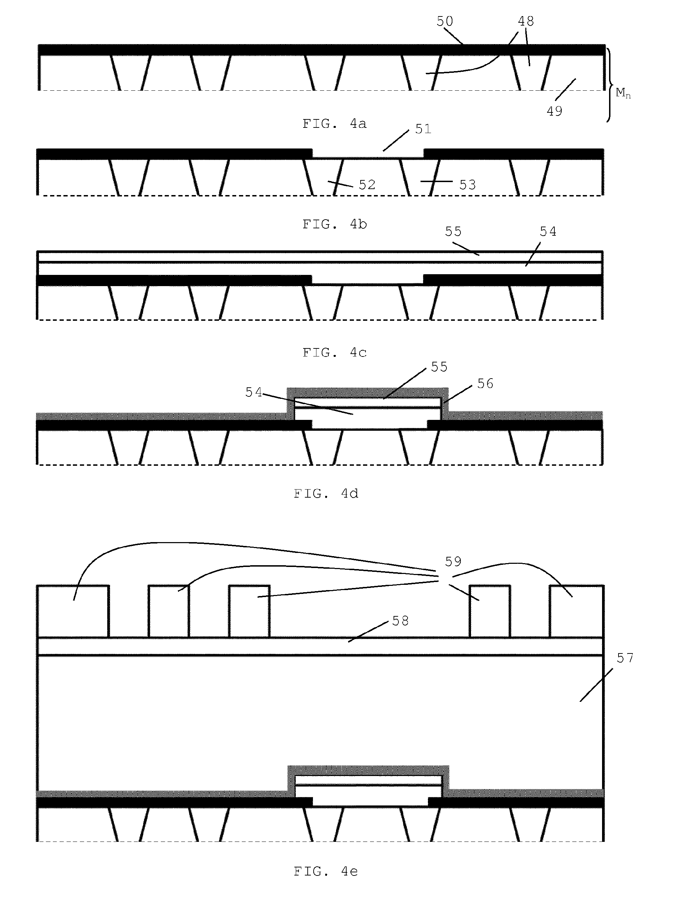

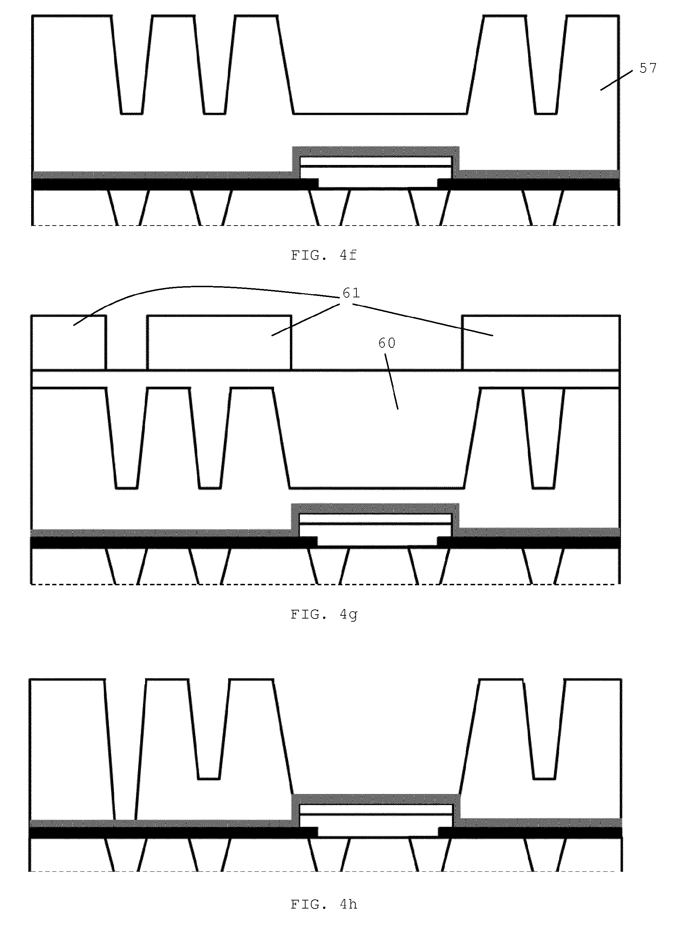

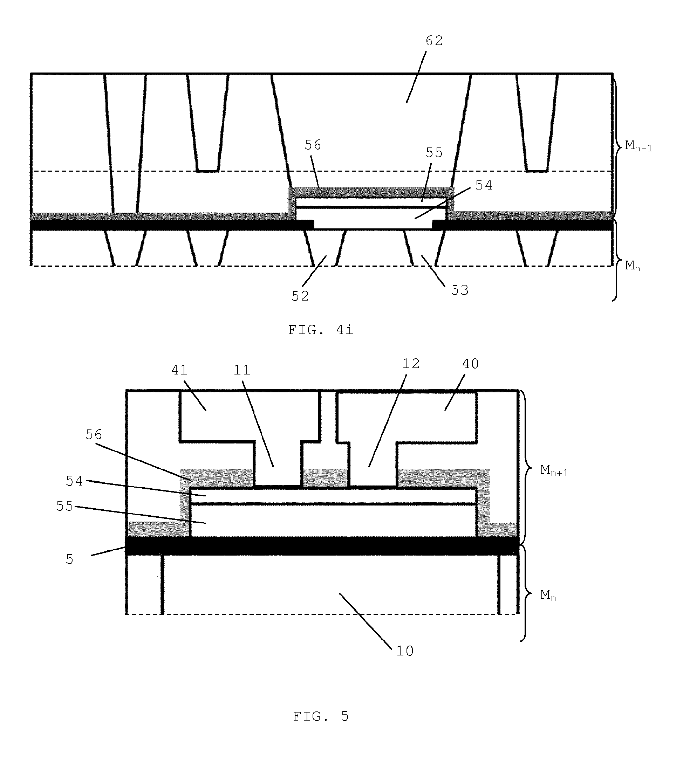

A process sequence for producing a transistor between two BEOL metallization layers according to the embodiment of Figure 2 is illustrated in Figure 4. Figure 4a shows the upper level of a first metallization layer Mₙ, comprising a number of metal lines 48, the intermetal dielectric 49 (preferably SiO₂) and a passivation layer 50, e.g. a layer of SiCN. An opening 51 is etched in the passivation layer 50 by known litho/etch steps (Figure 4b). The opening exposes at least a portion of two metal lines 52/53 in the Mₙ layer. After that, a thin film layer 54 of IGZO and a layer 55 of a suitable gate dielectric material, e.g. Al₂O₃ are sequentially deposited by a suitable deposition technique (Figure 4c). For example, a layer of between 10nm and 50nm of IGZO is deposited by PVD (Physical Vapour Deposition) and a layer of between 10nm and 50nm of Al₂O₃ is deposited on and in contact with the IGZO by ALD (Atomic Layer Deposition). Suitable conditions for the PVD and ALD processes are known to the skilled reader and not described here in detail. A patterning of the IGZO/Al₂O₃ stack is then performed, to obtain the stack 54/55 only on the required location (Figure 4d). An additional dielectric layer 56, for example a SiCN layer is deposited over the complete surface, covering the stack 56. This layer will act as etch stop layer during subsequent etching steps. Then the intermetal dielectric layer 57 of the next metallization layer Mₙ₊₁ is deposited, followed by deposition of a Bottom Anti-Reflective Coating (BARC) layer 58, in turn followed by the deposition and patterning of a resist layer 59 (Figure 4e). Through the patterned resist layer, the IMD layer 57 is etched a first time for forming trenches destined to be filled by metal lines in the upper level of Mₙ₊₁ (Figure 4f), after which a second BARC 60 and resist 61 are deposited and the second resist is patterned, after which a second etching step is done, to form openings destined to be filled by interconnect vias in the lower level of Mₙ₊₁ (Figure 4g and 4h). Etching of the vias stops on the etch stop layer 56. If the layer 55 can act as an etch stop layer, layer 56 may be omitted from the process. Metal deposition, preferably deposition of a seed layer and electrodeposition of copper, into the patterned trenches and vias is performed for forming all metal lines and interconnects, including the transistor gate electrode 62 on top of the IGZO/Al₂O₃/SiCN stack (Figure 4i). The described method step sequence does not exclude the presence of other method steps in between the steps of the sequence. Method steps that are routinely applied during BEOL processing have not been included in the above description for the sake of conciseness. For example, diffusion barrier layers will need to be deposited prior to deposition of metal lines and interconnect vias. In particular, in between the Cu metallization and the IGZO, a conductive layer is required that works as a diffusion barrier to the Cu. This can be e.g. a layer of Co, TaN, TiN.

The embodiment of Figure 1 can be processed by a similar process sequence, wherein however no patterning is required of the dielectric layer 5. The stack of layers 54 and 55 is deposited on the passivation layer 5, but in the inverse order compared to Figure 2 : first a gate dielectric layer 55 is deposited on the dielectric layer 5, followed by deposition of a thin film semiconductor layer 54 (preferably IGZO), after which the stack of these two layers is patterned to form a stack 55/54 only on top of a metal line 10 in a metallization layer Mₙ. Then an etch stop layer 56 is deposited (if required) and on top of said etch stop layer, a suitable set of litho/etch steps is performed, involving correctly defined resist masks, for producing metal-filled interconnect vias 11 and 12, and metal lines 41/40 connected to said vias. When the etch stop layer 56 is applied, this results in a power gating transistor as shown in Figure 5. As seen in this figure, the etch stop layer 56 itself is locally removed at the location of the source and drain 11/12. As known by the skilled person, this can be done by an additional litho/etch step, prior to the deposition of the metal-filled interconnect vias and metal lines.

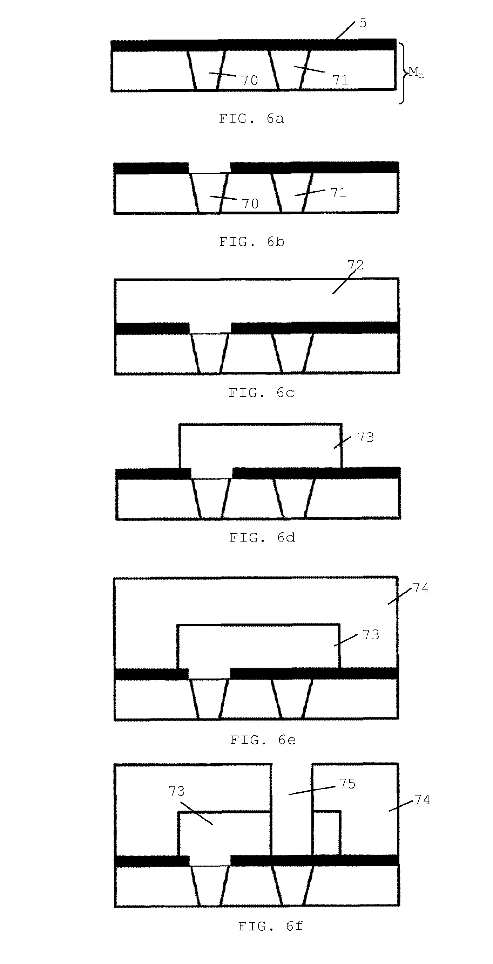

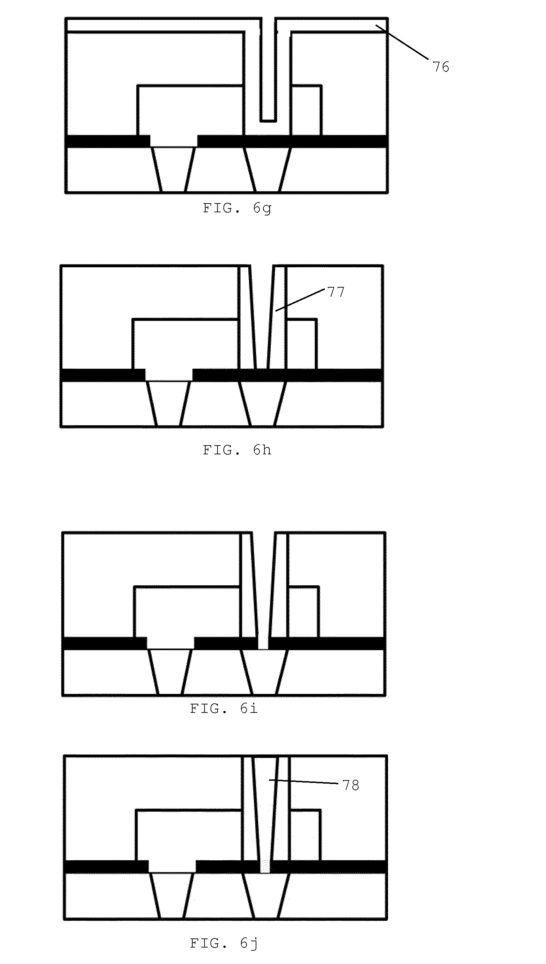

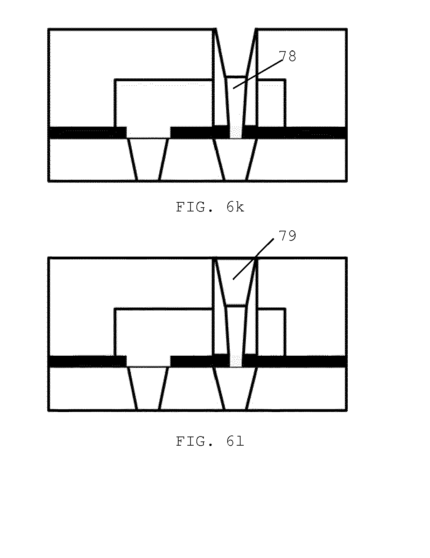

Figure 6 illustrates a possible process flow for producing a power gating transistor as shown in Figure 3. On a given metallization layer Mₙ comprising metal lines 70 and 71 and a dielectric layer 5 (e.g. SiCN) (Figure 6a), the SiCN layer is opened by a suitable litho/etch step above one of the metal lines 70 (Figure 6b). Then a metal layer 72 is deposited over the complete surface (Figure 6c). This may for example be a Ta layer. The Ta layer is itself patterned by litho/etch, so that a conductor 73 remains only on top of the metal lines 70/71 (Figure 6d). A layer 74 of intermetal dielectric, e.g. SiO₂ (Figure 6e) is then deposited, followed by litho/etch to open up said IMD layer above the second metal line 71 (Figure 6f) and form a via opening 75 through the IMD layer and through the conductor 73. A dielectric material suitable to serve as a gate dielectric, for example Al₂O₃ is deposited in the via opening, for example by ALD (atomic layer deposition), to form a layer 76 that lines the side wall and bottom of the opening and the upper surface of the IMD (Figure 6g).

The ALD deposited layer 76 is then removed from the upper surface of the IMD and from the bottom of the opening by a dry etching step, stopping on the SiCN layer 5, creating a narrowed opening with slanted sidewalls 77 formed of the gate dielectric material (Figure 6h). The SiCN layer 5 is then itself removed from the bottom of the opening (Figure 6i). Then a semiconductor material 78, for example a metal oxide with semiconductor properties, such as IGZO is deposited in the opening (Figure 6j). This can be done by growing an IGZO nanowire or by MOCVD (Metal Organic Chemical Vapour Deposition) or ALD of IGZO in the opening. The IGZO material is then etched back inside the opening, to about the upper level of the Ta conductor (Figure 6k), after which metal is deposited in the manner known in BEOL processing (e.g. Cu deposition including anti-diffusion layer, seed layer, copper plating) to form a conductor 79 at the top (Figure 6l) and thereby obtain the vertical transistor that is suitable to serve as a power gating transistor in an IC according to the invention.

The thin film semiconductor material that is applicable in an IC according to the invention must be suitable for producing a low leakage transistor. The thin film semiconductor layer is furthermore a layer that can be deposited, for example by PVD, CVD, ALD, solution deposition, on an amorphous substrate, i.e. it does not require a crystalline template. The thin film semiconductor must also be compatible with the thermal budget of BEOL processing, i.e. the material must not degrade at the temperatures used in the BEOL part of the IC's production process (typically 350-380°C). IGZO is a preferred option for the thin film semiconductor, but other materials may be possible, such as amorphous silicon, monocrystalline or polycrystalline silicon, graphene, Carbon nano tubes or metal oxides other than IGZO, e.g. ZnO, HfInZnO, SnO, CuO.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being present, deposited or produced 'on' another layer or substrate, includes the options of
- said layer being present, produced or deposited directly on, i.e. in physical contact with, said other layer or substrate, and
said layer being present, produced or deposited on one or a stack of intermediate layers between said layer and said other layer or substrate.

## Claims

1. An integrated circuit (IC) device comprising a front-end-of-line portion (1) and a back-end-of-line (BEOL) portion, the BEOL portion comprising a plurality of metallization layers (Mₙ), said layers comprising metal lines (2) and metal-filled interconnect vias (3), the IC further comprising a plurality of power gating transistors wherein at least one of said power gating transistors (100) is located in said BEOL portion.

2. Integrated circuit device according to claim 1, wherein said at least one power gating transistor (100) in the BEOL portion comprises a gate electrode (10,24), a source electrode and a drain electrode (11,12,20,21), a channel region (13,22) and a gate dielectric region (5,14,17,23), wherein said gate, source and drain electrodes are formed by metal lines or metal-filled interconnect vias of said metallization layers.

3. Integrated circuit device according to claim 2, wherein said channel region (13,) is a planar semiconductor layer, and wherein said gate dielectric region (5,14,17) is a planar layer of dielectric material and wherein said layers form a stack of layers between the gate electrode (10) on the one hand and the source and drain electrodes (11,12) on the other hand.

4. Integrated circuit device according to claim 3, wherein said gate electrode is formed by a metal line (10) in a first metallization layer (Mₙ), and the source and drain electrodes are formed by metal-filled interconnect vias (11,12) in a second metallization layer (Mₙ₊₁) directly on top of the first metallization layer (Mₙ).

5. Integrated circuit device according to claim 3, wherein said source and drain electrodes (10,11) are formed by a pair of metal lines in a first metallization layer (Mₙ) and the gate electrode (10) is formed by a metal-filled via interconnect (10) in a second metallization layer (Mₙ₊₁) directly on top of the first metallization layer (Mₙ).

6. Integrated circuit device according to claim 1, wherein said at least one power gating transistor (100) in the BEOL portion comprises a gate electrode(24), a source electrode and a drain electrode, a channel region (22) and a gate dielectric region (23), wherein said source and drain electrodes (20,21) are formed by a pair of conductors, the first conductor (20) being located in a first metallization layer (Mₙ), the second conductor (21) in a second metallization layer (Mₙ₊₁) which is directly on top of the first metallization layer (Mₙ), the source and drain electrodes being physically located essentially one directly above the other, with the channel region (22) being located in between the source and drain electrodes (20,21) and the channel region (22) being in electrical contact with the source and drain electrodes (20,21), the channel region (22) and gate dielectric region (23) being located in a via opening located above the first conductor (20), the gate dielectric region surrounding the channel region, and wherein the gate electrode (24) is a conductor in contact with the gate dielectric (23) and formed at least partially surrounding said via opening.

7. Integrated circuit according to claim 6, wherein the second conductor (21) is also located in said via opening.

8. Integrated circuit according to claim 6 or 7, wherein the first conductor (20) is a metal line in the first metallization layer (Mn).

9. Integrated circuit device according to any one of claims 1 to 8, wherein said channel region is formed of Indium Gallium Zinc Oxide (IGZO).

10. Integrated circuit device according to any one of the preceding claims, wherein said power gating transistor is located in the three first metallization layers (M1,M2,M3) of the device.
